(19) Europäisches Patentamt
European Patent Office
Office européen des brevets

(11) **EP 2 840 402 B1**

(12) **EUROPEAN PATENT SPECIFICATION**

(45) Date of publication and mention
of the grant of the patent:
**29.04.2020 Bulletin 2020/18**

(21) Application number: **13778490.6**

(22) Date of filing: **18.02.2013**

(51) Int Cl.:
*G01R 21/00* (2006.01)     *H02J 13/00* (2006.01)
*H02J 3/00* (2006.01)

(86) International application number:
**PCT/JP2013/053854**

(87) International publication number:
**WO 2013/157294 (24.10.2013 Gazette 2013/43)**

(54) **OPERATING STATE ESTIMATING DEVICE FOR ELECTRICAL APPARATUS, OPERATING STATE ESTIMATING METHOD FOR ELECTRICAL APPARATUS, PROGRAM, FEATURE VECTOR REGISTRATION DEVICE FOR ELECTRICAL APPARATUS, FEATURE VECTOR REGISTRATION METHOD FOR ELECTRICAL APPARATUS, SERVER APPARATUS, AND OPERATING STATE ESTIMATING SYSTEM FOR ELECTRICAL APPARATUS**

BETRIEBSZUSTANDSSCHÄTZUNGSVORRICHTUNG FÜR EINE ELEKTRISCHE VORRICHTUNG, BETRIEBSZUSTANDSSCHÄTZUNGSVERFAHREN FÜR EINE ELEKTRISCHE VORRICHTUNG, PROGRAMM, MERKMALSVEKTORREGISTRIERUNGSVORRICHTUNG FÜR EINE ELEKTRISCHE VORRICHTUNG, MERKMALSVEKTORREGISTRIERUNGSVERFAHREN FÜR EINE ELEKTRISCHE VORRICHTUNG, SERVERVORRICHTUNG UND BETRIEBSZUSTANDSSCHÄTZUNGSSYSTEM FÜR EINE ELEKTRISCHE VORRICHTUNG

DISPOSITIF D'ESTIMATION D'ÉTATS DE FONCTIONNEMENT POUR APPAREIL ÉLECTRIQUE, PROCÉDÉ D'ESTIMATION D'ÉTATS DE FONCTIONNEMENT POUR APPAREIL ÉLECTRIQUE, PROGRAMME, DISPOSITIF D'ENREGISTREMENT DE VECTEURS DE CARACTÉRISTIQUES POUR APPAREIL ÉLECTRIQUE, PROCÉDÉ D'ENREGISTREMENT DE VECTEURS DE CARACTÉRISTIQUES POUR APPAREIL ÉLECTRIQUE, APPAREIL DE SERVEUR, ET SYSTÈME D'ESTIMATION D'ÉTATS DE FONCTIONNEMENT POUR APPAREIL ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.04.2012  JP 2012094457**

(43) Date of publication of application:
**25.02.2015  Bulletin 2015/09**

(73) Proprietor: **Sony Corporation**
**Tokyo 108-0075 (JP)**

(72) Inventors:
• **ABE, Mototsugu**
**Tokyo 108-0075 (JP)**
• **SHIBUYA, Takashi**
**Tokyo 108-0075 (JP)**

• **NISHIGUCHI, Masayuki**
**Tokyo 108-0075 (JP)**

(74) Representative: **D Young & Co LLP**
**120 Holborn**
**London EC1N 2DY (GB)**

(56) References cited:
WO-A1-2011/002735     JP-A- 2004 056 969
JP-A- 2006 017 456     JP-A- 2011 014 156
US-A1- 2011 251 807     US-A1- 2011 301 894

• **HART G W: "NONINTRUSIVE APPLIANCE LOAD MONITORING", PROCEEDINGS OF THE IEEE, IEEE. NEW YORK, US, vol. 80, no. 12, 1 December 1992 (1992-12-01), pages 1870-1891, XP000336363, ISSN: 0018-9219, DOI: 10.1109/5.192069**

**Description**

TECHNICAL FIELD

The present technology relates to an operational state estimating apparatus for an electrical device, an operational state estimating method for the electrical device, a program, a feature vector registering apparatus for the electrical device, a feature vector registering method for the electrical device, a server device, and an operational state estimating system for the electrical device.

BACKGROUND ART

Because of the spread of global environmental problems and the like, demands have been increasing for grasping, in detail, electricity usage conditions of electrical devices owned by each household and each individual. For example, by visualizing the electricity usage condition of each device in a household at every moment, electricity charges can be saved by turning off unnecessary electrical devices. Further, electricity can be effectively saved when power supply is strained.

In the past, an electricity usage amount has been measured by an electric energy meter in a unit for imposing electricity charges such as a household unit (see, for example, Patent Document 1). In some quarters, the electricity usage amount has been measured in a smaller unit by disposing a dedicated tool near each electrical device such as an outlet.

CITATION LIST

PATENT DOCUMENT

Patent Document 1: JP 2002-354560 A Hart G W, "Nonintrusive Appliance Load Monitoring", Proceedings of the IEEE, IEEE New York, US, 1 December 1992, Vol. 80, No. 12 , pages 1870-1891 discloses a nonintrusive load appliance monitor determining energy composition of individual appliances, based on analysis of the normalized power of the total load. An algorithm is disclosed in which step-changes in the power load signal are detected and attributed to a device. Devices can be characterized based on the duration in which their state is active.

US 2011/0301894 discloses a system and method for use in a non-intrusive load monitoring system to identify specific types of loads and communicate the identified load information to interested parties. The non-intrusive load monitoring system includes an electricity meter that measures load information from a home or facility. The load information is analyzed by comparing the information to a series of load signatures for various known electrical loads to identify the specific type of electric load. Once the type of load is identified, the system utilizes the information to analyze the operation of the load and relay messages to the home owner regarding such operation. The load information may be used by a utility to better predict and manage peak and average electricity consumption over the year. WO 2011/002735 discloses apparatus and method including acquiring a signal indicative of power consumption; detecting a transient in the signal; extracting a feature indicative of the transient by fitting a plurality of models to the transient, selecting one of the plurality of models as a model for the transient, and defining the feature indicative of the transient based on at least one parameter of the model for the transient; and classifying the transient based on the feature.

US 2011/0251807 discloses identifying an electrical device, and its state, in a network of electrical devices. An energy monitoring device is programmed to identify an electrical device coupled to a power supply, and a state of the electrical device, from a change in successive measurements of the power supply. Algorithms for determining a load signature for an electrical device and its state are disclosed. A stored table of load signatures for states is used to identify devices, and states. Energy monitoring information is collected and presented to the user on a display, a remote display, or is transmitted over a network to a remote device such as a personal computer, personal digital assistant, an iPhone TM , a cell phone, voice mail, email, or text message.

SUMMARY OF THE INVENTION

PROBLEMS TO BE SOLVED BY THE INVENTION

A total amount of electricity usage is sufficient for calculating electricity charges. However, it is less useful for effectively saving electricity according to time and circumstances. On the other hand, disposing a dedicated tool on each outlet requires labor and costs. Therefore, it has not been prevailed.

An object of the present technology is to appropriately estimate operational states of a plurality of electrical devices connected to an electrical power line, that is, an electricity usage condition.

SOLUTIONS TO PROBLEMS

The invention is defined by the appended claims.

A concept of the present technology is an operational state estimating apparatus for an electrical device including:

a current-voltage measuring unit configured to measure current and voltage as time-series from an electrical power line to which a plurality of electrical devices is connected;

a filtering unit configured to filter signal components of power frequency and harmonics thereof from the time-series of the measured current and voltage;

an admittance calculating unit configured to calculate admittance vector time-series from the filtered signal components;

a feature vector retaining unit configured to retain feature vectors of the plurality of electrical devices;

a combination calculating unit configured to calculate combination patterns of the retained feature vectors of the plurality of electrical devices; and

a comparing unit configured to compare the combined feature vectors and the calculated admittance vector time-series to obtain an estimated result of the operational states of the plurality of electrical devices.

In the present technology, the current and voltage are measured as the time-series by the current-voltage measuring unit from the electrical power line to which the plurality of electrical devices is connected. The signal components of the power frequency and the harmonics thereof are filtered by the filtering unit from the time-series of those measured current and voltage. Further, the admittance vector time-series are calculated by the admittance calculating unit from the signal components filtered by the filtering unit. In such a case, the admittance vector includes admittances of both the power frequency and the harmonics thereof as elements.

The feature vectors of the plurality of electrical devices are retained in the feature vector retaining unit. For example, a feature vector of a predetermined electrical device includes one or a plurality of feature vectors extracted, by vector quantization, from admittance vector time-series when the predetermined electrical device is in an operational state. The combination patterns of the retained feature vectors of the plurality of electrical devices are calculated by the combination calculating unit.

For example, the combination calculating unit may be configured so as to calculate all the combination patterns of the retained feature vectors. By calculating all the combination patterns in this manner, the estimated result of the operational states of the plurality of electrical devices can be obtained with high accuracy.

Further, for example, the combination calculating unit may be configured so as to calculate combination patters, in which the operational states of the devices have been stochastically changed, from an estimated result of the latest device operational state based on combination patterns in which the operational states of devices within a predetermined quantity have been changed and/or based on a predetermined probability distribution. In such a case, the predetermined probability distribution may be one calculated from past histories of the operational states of the plurality of electrical devices. Further, in such a case, the predetermined probability distribution may be one according to time that is selected from a plurality of probability distributions calculated according to day and time. In such a case, the quantity of the combination patterns as well as a processing load can be reduced.

The combined feature vectors are compared with the calculated admittance vector time-series by the comparing unit to obtain the estimated result of the operational states of the plurality of electrical devices. For example, the comparing unit calculates inter-vector distances between the combined feature vectors and the calculated admittance vector time-series. A combination having the shortest distance is set as the estimated result of the operational states of the plurality of electrical devices.

As mentioned above, in the present technology, the admittance vector time-series obtained based on the current and voltage measured by the electrical power line are compared with the combinations of the feature vectors of the plurality of electrical devices connected to the electrical power line to obtain the estimated result of the operational states of the plurality of electrical devices. Herein, it is possible to appropriately estimate the operational states of the plurality of electrical devices, that is, an electricity usage condition.

Another concept of the present technology is a feature vector registering apparatus for an electrical device, including:

a current-voltage measuring unit configured to measure current and voltage as time-series from an electrical power line to which a plurality of electrical devices is connected;

a filtering unit configured to filter signal components of power frequency and harmonics thereof from the time-series of the measured current and voltage;

an admittance calculating unit configured to calculate admittance vector time-series from the filtered signal components;
a feature vector extracting unit configured to extract feature vectors of each of the plurality of electrical devices from the calculated admittance vector time-series; and
a feature vector registering unit configured to register, on a database, the extracted feature vectors of the plurality of electrical devices.

In the present technology, the current and voltage are measured as the time-series by the current-voltage measuring unit from the electrical power line to which the plurality of electrical devices is connected. The signal components of the power frequency and the harmonics thereof are filtered by the filtering unit from the time-series of those measured current and voltage. Then, the admittance vector time-series are calculated from the filtered signal components by the admittance calculating unit. In such a case, the admittance vector includes admittances of both the power frequency and the harmonics thereof as elements.

The feature vectors of each of the plurality of electrical devices are extracted by the feature vector extracting unit from the calculated admittance vector time-series. Further, the extracted feature vectors of the plurality of electrical devices are registered on the database by the feature vector registering unit.

For example, when it is possible to drive only a predetermined electrical device, the feature vector extracting unit may be configured to extract one or a plurality of feature vectors, as a feature vector of the predetermined electrical device, from the admittance vector time-series by vector quantization.

Further, for example, when it is difficult to drive only the predetermined electrical device, the feature vector extracting unit may be configured to estimate admittance vector time-series of the predetermined electrical device from the calculated admittance vector time-series, and to extract one or a plurality of feature vectors, as the feature vector of the predetermined electrical device, from the admittance vector time-series by the vector quantization.

In such a case, for example, the feature vector extracting unit may be configured to estimate admittance vector time-series of an electrical device other than the predetermined electrical device from the calculated admittance vector time-series in a case where the predetermined electrical device is not in an operational state. Then, the feature vector extracting unit may be configured to extract the admittance vector time-series of the predetermined electrical device by removing an estimate value of the admittance vector time-series of the electrical device other than the predetermined electrical device from the calculated admittance vector time-series in a case where the predetermined electrical device is in the operational state.

In such a case, for example, the feature vector extracting unit may be configured to estimate the admittance vector time-series of the electrical device other than the predetermined electrical device by according and compositing phases of the calculated admittance vector time-series in time periods before and after driving the predetermined electrical device so that a correlation value of the admittance vector time-series becomes the highest.

As mentioned above, in the present technology, the feature vectors of each of the plurality of electrical devices connected to the electrical power line can be favorably extracted and registered on the database from the admittance vector time-series obtained based on the current and voltage measured by the electrical power line.

Another concept of the present technology is an operational state estimating apparatus for an electrical device including:

a current-voltage measuring unit configured to measure current and voltage as time-series from an electrical power line to which a plurality of electrical devices is connected;
a filtering unit configured to filter signal components of power frequency and harmonics thereof from the time-series of the measured current and voltage;
an admittance calculating unit configured to calculate admittance vector time-series from the filtered signal components;
an admittance transmitting unit configured to transmit the calculated admittance vector time-series to a server device; and
an estimated result receiving unit configured to receive an estimated result of the operational states of the plurality of electrical devices from the server device.

In the present technology, the current and voltage are measured as the time-series by the current-voltage measuring unit from the electrical power line to which the plurality of electrical devices is connected. The signal components of the power frequency and the harmonics thereof are filtered by the filtering unit from the time-series of those measured current and voltage. Further, the admittance vector time-series are calculated by the admittance calculating unit from the signal components filtered by the filtering unit. In such a case, the admittance vector includes admittances of both the power frequency and the harmonics thereof as elements.

The calculated admittance vector time-series are transmitted to the server device by the admittance transmitting unit. The estimated result of the operational states of the plurality of electrical devices is received by the estimated result receiving unit from the server device.

As mentioned above, the present technology does not carry out a process of estimating the operational states of the plurality of electrical devices connected to the electrical power line from the admittance vector time-series. Instead, the server device carries out the process. Accordingly, it is possible to reduce a processing load and to obtain the estimated result with high accuracy due to a high-performance process of the server device.

Further, another concept of the present technology is a server device, including:

an admittance receiving unit configured to receive admittance vector time-series transmitted from a terminal device;

a feature vector retaining unit configured to retain feature vectors of a plurality of electrical devices;

a combination calculating unit configured to calculate combination patterns of the retained feature vectors of the plurality of electrical devices;

a comparing unit configured to compare the combined feature vectors and the received admittance vector time-series to obtain an estimated result of the operational states of the plurality of electrical devices; and

an estimated result transmitting unit configured to transmit the obtained estimated result of the operational states of the plurality of electrical devices to the terminal device.

In the present technology, the admittance vector time-series transmitted from the terminal device are received by the admittance receiving unit. The combination patterns of the feature vectors of the plurality of electrical devices retained by an admittance vector retaining unit are calculated by the combination calculating unit. Note that the feature vectors of the plurality of electrical devices retained by the feature vector retaining unit may be, for example, extracted in advance by the server device itself from the admittance vector time-series transmitted from the terminal device. Alternatively, the feature vectors may be received in advance from the terminal device.

The combined feature vectors and the received admittance vector time-series are compared by the comparing unit to obtain the estimated result of the operational states of the plurality of electrical devices. Then, the obtained estimated result of the operational states of the plurality of electrical devices is transmitted to the terminal device by the estimated result transmitting unit.

As mentioned above, the present technology carries out, instead of the terminal device, a process of estimating the operational states of the plurality of electrical devices connected to the electrical power line from the admittance vector time-series. Accordingly, it is possible to reduce the processing load of the terminal device and to provide the estimated result to the terminal device with high accuracy due to the high-performance process.

Note that in the present technology, for example, the terminal device may further include a request-to-send receiving unit configured to receive a request-to-send of the estimated result transmitted from another terminal device different the terminal devices. Further, the estimated result transmitting unit may transmit the obtained estimated result of the operational states of the plurality of electrical devices to the other terminal device based on the received request-to-send. As a result, it is possible for a user to confirm the estimated result of the operational states of the plurality of electrical devices by other terminals (portable terminal) different from a fixed terminal device.

EFFECTS OF THE INVENTION

According to the present technology, it is possible to appropriately estimate operational states of a plurality of electrical devices connected to an electrical power line, that is, an electricity usage condition.

BRIEF DESCRIPTION OF DRAWINGS

Fig. 1 is a block diagram showing an exemplary configuration of an operational state estimating apparatus for an electrical device as a first embodiment of the present technology.

Fig. 2 is a flow chart showing a process of estimating admittance vector time-series of a single target device in a first case where it is possible to turn off all the other connected devices (to set in a non-operational state).

Fig. 3 is a view for explaining phase adjustment of admittance vector time-series Ybef(n) and Yaft(n) in a case of estimating composite admittance vector time-series Yoth(n) of an electrical device other than the target device.

Fig. 4 is a flow chart showing a process of estimating admittance vector time-series of the single target device in a second case where there exist other connected devices that work at all times.

Fig. 5 is a schematic view of vector quantization.

Fig. 6 is a view showing an example of feature vectors registered on a feature vector database.

Fig. 7 is a view showing an integral process of an operational state estimating method in a case of a small quantity of devices.

Fig. 8 is a view showing an integral process of the operational state estimating method in a case of a large quantity of devices.

Fig. 9 is a block diagram showing an example of a computer device that executes a device registration process and an electricity usage condition determining process with software.

Fig. 10 is a block diagram showing an exemplary configuration of an operational state estimating system for an electrical device as a second embodiment.

Fig. 11 is a block diagram showing an exemplary configuration of an operational state estimating apparatus included in the operational state estimating system for the electrical device.

Fig. 12 is a block diagram showing an exemplary configuration of a server device included in the operational state estimating system for the electrical device.

MODES FOR CARRYING OUT THE INVENTION

The following is a mode for carrying out the invention (hereinafter referred to as the "embodiment"). Explanation will be made in the following order.

1. First Embodiment
2. Second Embodiment
3. Modifications

<1. First Embodiment>

[Operational State Estimating Apparatus For Electrical Device]

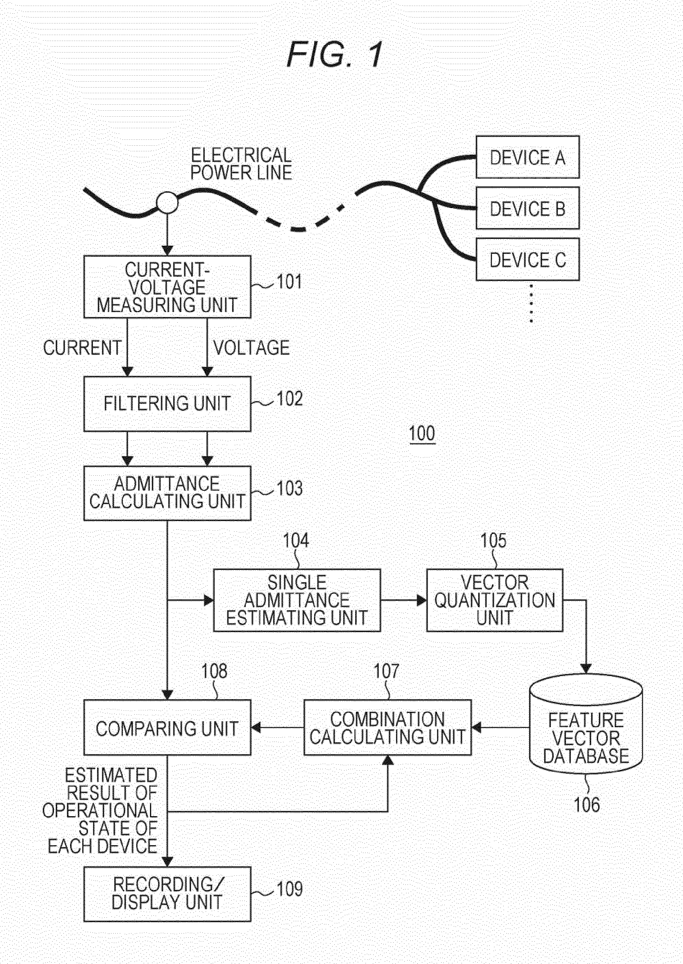

Fig. 1 is a view showing an exemplary configuration of an operational state estimating apparatus 100 for an electrical device as a first embodiment of the present technology. This operational state estimating apparatus 100 executes a device registration process and an electricity usage condition determining process. This operational state estimating apparatus 100 includes a current-voltage measuring unit 101, a filtering unit 102, an admittance calculating unit 103, a single admittance estimating unit 104, and a vector quantization unit 105. Further, the operational state estimating apparatus 100 includes a feature vector database 106, a combination calculating unit 107, a comparing unit 108, and a recording/display unit 109.

The current-voltage measuring unit 101 measures current and voltage from an electrical power line to which a plurality of electrical devices (device A, device B, device C and the like) is connected. This current-voltage measuring unit 101 measures the current and voltage values at every moment at one part of the base of the electrical power line, and obtains time-series of digital data by A/D conversion.

The filtering unit 102 filters signal components of power frequency and harmonics thereof from the time-series of the current and voltage measured by the current-voltage measuring unit 101. In other words, the filtering unit 102 calculates complex narrow-band current Ik(n) shown in the following Mathematical Formula 1 and complex narrow-band voltage Vk(n) shown in the following Mathematical Formula 2. Both of them correspond to each odd-order harmonics "k" in a time frame "n" with respect to current I(t) and voltage V(t) relating discrete-time "t".

[Mathematical Formula 1]

$$I_k(n) = \sum_{t=-W/2}^{W/2-1} w(t) I(t-nT) e^{-j2\pi(2k+1)ft} \quad \cdots (1)$$

$$V_k(n) = \sum_{t=-W/2}^{W/2-1} w(t) V(t-nT) e^{-j2\pi(2k+1)ft} \quad \cdots (2)$$

Note that "n" represents a frame number, "k" represents a harmonics quantity, "f" represents power frequency (50 Hz or 60 Hz), "T" represents a time interval of the frame, "w(t)" represents a window function such as a Hann window, and "W" represents a size of the window function. To determine the harmonics, k is calculated from a range where k represents one (k = 1) to a range where k represents a predetermined quantity K (k = K). Based on this calculation, Ik(n) becomes a complex time-series of current in which a narrow-band component near frequency (2k + 1)f has been re-sampled at the time interval T. Similarly, Vk(n) becomes a complex time-series of voltage in which a narrow-band component near frequency (2k + 1)f has been re-sampled at the time interval T.

The admittance calculating unit 103 calculates the admittance vector time-series from the signal components filtered by the filtering unit 102. In other words, the admittance calculating unit 103 calculates admittances Yk(n) in the present time "n" from the current Ik(n) and the voltage Vk(n), as shown in the following Mathematical Formula 3.

[Mathematical Formula 2]

$$Y_k(n) = \frac{I_k(n)}{V_k(n)} \quad \cdots (3)$$

Herein, the admittances of the calculated power frequency and the harmonics thereof are collectively described as K-dimensional vectors, as shown in the following Mathematical Formula 4, and are referred to as admittance vector time-series.

[Mathematical Formula 3]

$$Y(n) = [Y_1(n), Y_2(n), \ldots, Y_K(n)] \quad \cdots (4)$$

Processes of the current-voltage measuring unit 101, the filtering unit 102, and the admittance calculating unit 103 are common in both the device registration process and the electricity usage condition determining process. In the device registration process, admittance vector time-series of a device to be registered are estimated. Herein, a feature vector is extracted and is registered on the feature vector database 106. The single admittance estimating unit 104 and the vector quantization unit 105 function for the device registration process.

The single admittance estimating unit 104 serially sets, as a target device, the plurality of electrical devices (device A, device B, device C and like) connected to the electrical power line. Then, the single admittance estimating unit 104 estimates admittance vector time-series of the single target device.

In a first case where it is possible to turn off all the other connected devices (to set in a non-operational state), when only the target device is turned on (set in an operational state), the single admittance estimating unit 104 observes a predetermined frame quantity N of output of the admittance calculating unit 103 to obtain admittance vector time-series Y(n) of the single target device.

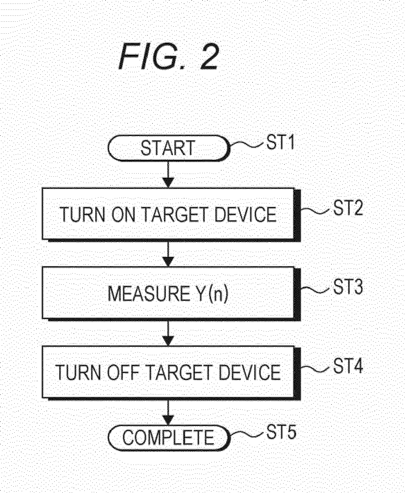

Fig. 2 is a view showing a flow chart of a process in the first case. In Step ST1, the process is started. Next, in Step ST2, the target device is turned on (set in the operational state). Next, in Step ST3, by the single admittance estimating unit 104, the predetermined frame quantity (N) of the output of the admittance calculating unit 103 is observed, and the admittance vector time-series Y(n) of the single target device are measured. Next, in Step ST4, the target device is turned off (set in the non-operational state). Finally, in Step ST5, the process is completed.

Further, in a second case where there exist other connected devices that work at all times such as a refrigerator, the single admittance estimating unit 104 cannot directly obtain the admittance vector time-series Y(n) of the single target device. Therefore, the single admittance estimating unit 104 estimates the admittance vector time-series Y(n) of the single target device as hereinafter described.

First, the single admittance estimating unit 104 observes a predetermined frame quantity (3N) or more of the output of the admittance calculating unit 103, when the target device is turned off (set in the non-operational state). Then, the single admittance estimating unit 104 obtains admittance vector time-series Ybef(n). Next, the single admittance estimating unit 104 observes the output of the admittance calculating unit 103 throughout the predetermined frame quantity (N), when the target device is turned on (operational state). Then, the single admittance estimating unit 104 obtains admittance vector time-series Yon(n). Next, the single admittance estimating unit 104 repeatedly observes the predetermined frame quantity (3N) or more of the output of the admittance calculating unit 103, when the target device is turned off (set in the non-operational state). Then, the single admittance estimating unit 104 obtains admittance vector time-series Yaft(n).

Next, the single admittance estimating unit 104 estimates composite admittance vector time-series Yoth(n) of an electrical device other than the target device by the calculation shown in the following Mathematical Formula 5.

[Mathematical Formula 4]

$$Y_{\text{oth}}(n) = \frac{1}{2}\left(Y_{\text{aft}}(n + \tau_{\text{aft}}) + Y_{\text{bef}}(n + \tau_{\text{bef}})\right) \quad (n = 0, \ldots, N-1) \quad \cdots (5)$$

$$\left[ \begin{array}{l} \tau_{\text{aft}} = \displaystyle\arg\min_{\tau = N, \ldots, 2N-1} \sum_{n=0}^{N-1} |Y_{\text{bef}}(n + 2N) - Y_{\text{aft}}(n + \tau)|^2 \\[4mm] \tau_{\text{bef}} = \displaystyle\arg\min_{\tau = 0, \ldots, N-1} \sum_{n=0}^{N-1} |Y_{\text{aft}}(n) - Y_{\text{bef}}(n + N + \tau)|^2 \end{array} \right]$$

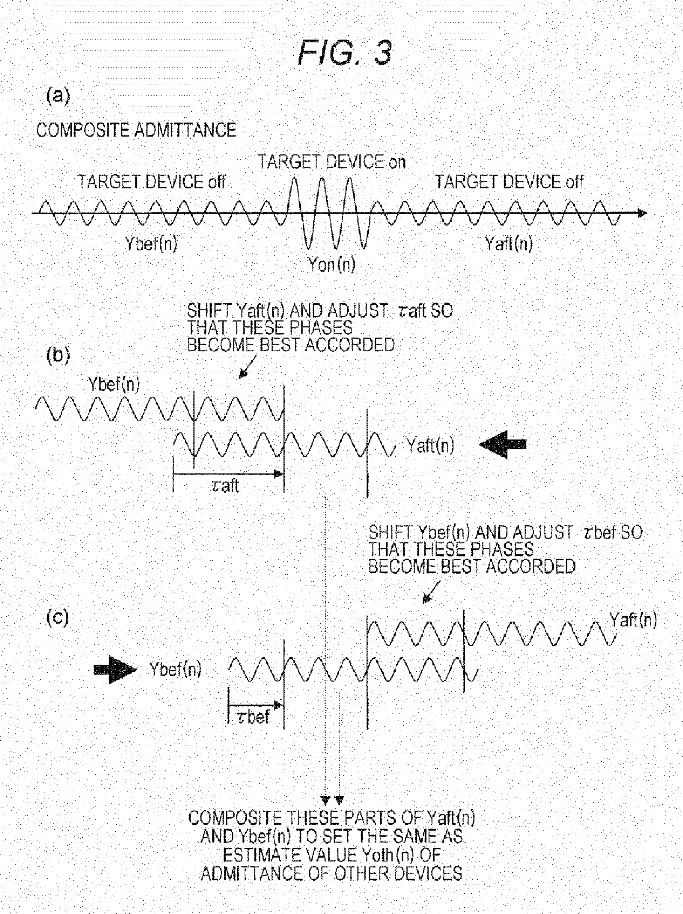

Fig. 3(a) is a view showing an example of Ybef(n), Yon(n), and Yaft(n) measured by the single admittance estimating unit 104. As shown in Fig. 3(b), $\tau$aft in Mathematical Formula 5 represents an adjusted phase amount which is best accorded with a phase of the admittance vector time-series Ybef(n) when a phase of the admittance vector time-series Yaft(n) is shifted. As shown in Fig. 3(c), $\tau$bef in Mathematical Formula 5 represents an adjusted phase amount which is best accorded with a phase of the admittance vector time-series Yaft(n) when a phase of the admittance vector time-series Ybef(n) is shifted.

The composite admittance vector time-series Yoth(n) shown in Mathematical Formula 5 is one that averages a part of the predetermined frame quantity (N) in which the admittance vector time-series Yon(n) of the phase adjusted admittance vector time-series Yaft(n) and Ybef(n) can be obtained.

Next, as shown in the following Mathematical Formula 6, the composite admittance vector time-series Yoth(n) of the electrical device other than the target device are subtracted from the admittance vector time-series Yon(n) obtained when the target device is turned on (set in the operational state). As a result, the admittance vector time-series Y(n) of the single target device are estimated.

[Mathematical Formula 5]

$$Y(n) = Y_{\text{on}}(n) - Y_{\text{oth}}(n) \quad \cdots (6)$$

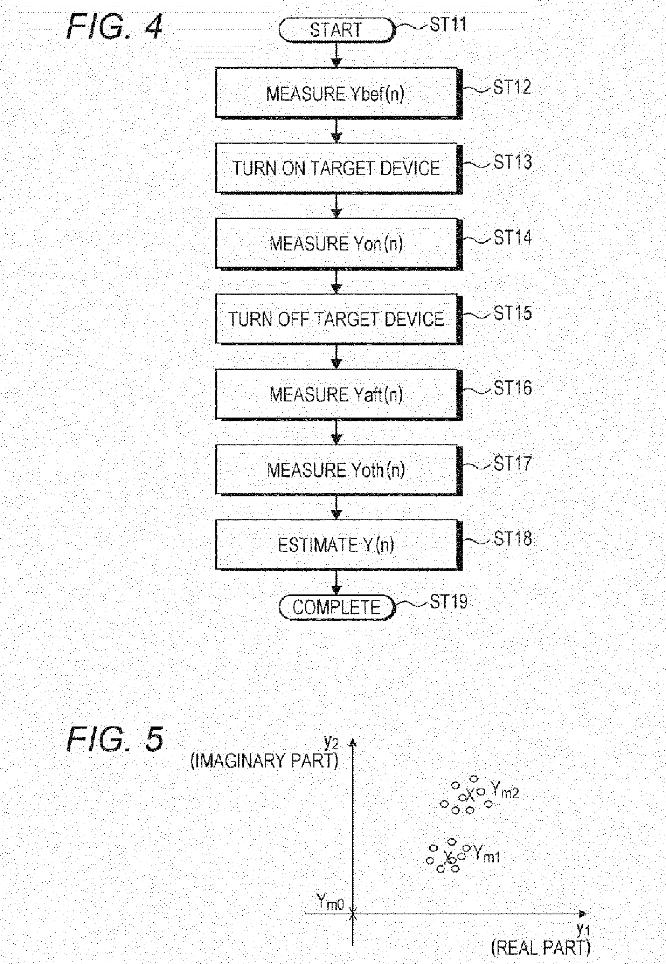

A flow chart shown in Fig. 4 illustrates a process in the second case. In Step ST11, the process is started. Next, in Step ST12, the predetermined frame quantity (3N) or more of the output of the admittance calculating unit 103 is observed, when the target device is turned off (set in the non-operational state). Then, the admittance vector time-series Ybef(n) are measured.

Next, in Step ST13, the target device is turned on (set in the operational state). Next, in Step ST14, the output of the admittance calculating unit 103 only within the predetermined frame quantity (N) is observed. Then, the admittance vector time-series Yon(n) are measured.

Next, in Step ST15, the target device is turned off (set in the non-operational state). Next, in Step ST16, the predetermined frame quantity (3N) or more of the output of the admittance calculating unit 103 is observed, when the target device is turned off (set in the non-operational state). Then, the admittance vector time-series Yaft(n) are measured.

Next, in Step ST17, the composite admittance vector time-series Yoth(n) of the electrical device other than the target device are measured by the Mathematical Formula 5. Next, in Step ST18, as shown in Mathematical Formula 6, the composite admittance vector time-series Yoth(n) are subtracted from the admittance vector time-series Yon(n). Then, the admittance vector time-series Y(n) of the single target device are estimated. Finally, in Step ST19, the process is completed.

Back to Fig. 1, the vector quantization unit 105 executes the vector quantization so that the admittance vector time-series Y(n), throughout the N frame of each device, estimated by the single admittance estimating unit 104 are represented by a predetermined quantity C (C is sufficiently smaller than N) of feature vectors. Fig. 5 is a schematic view of the vector quantization. Herein, "O" represents admittance vector time-series Y(n) of an m-th target device, while "×" represents a vector quantized representative vector Ymc.

The vector quantization can be carried out, for example, by so-called k-means clustering such as Lloyd algorithm. Hereinafter, a total quantity of the devices is denoted by "M", ID of the target device is denoted by "m", the number of the feature vector is denoted by "c", and the c-th feature vector of the m-th device is denoted by "Ymc". Further, in order to simplify subsequent calculations, a zero vector is conveniently added as a feature vector in a case where c equals zero (c = 0). Herein, Ym0 equals zero (Ym0 = [0, ..., 0]). This vector represents that the device is turned off (set in the non-operational state).

The vector quantization unit 105 carries out the above-mentioned vector quantized calculation with respect to all devices, and registers the representative vector Ymc of each device on the feature vector database 106. Accordingly, M × (C + 1) quantities of the feature vectors are registered on the feature vector database. Herein, "m" of "Ymc" represents from one to "M", while "c" thereof represents from zero to "C" (m = 1, ... M, c = 0, ... C) .

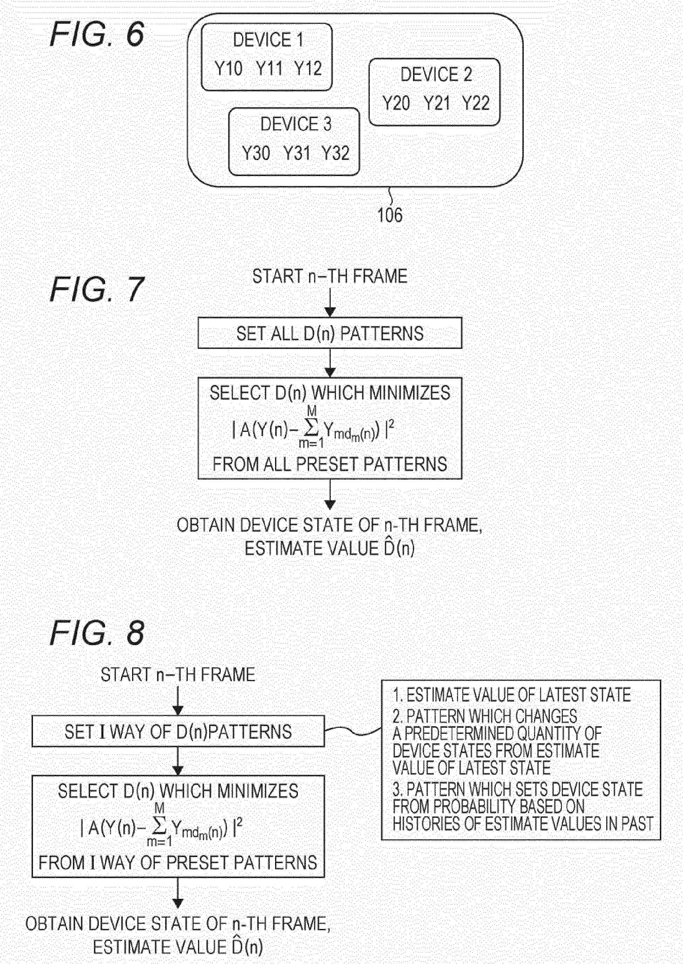

Fig. 6 is a view showing an example of the feature vectors registered on the feature vector database 106. The example shows a case where M (device quantity) is three (M = 3), and C (vector quantity when each device is in the operational state) is two (C = 2). The feature vector Ym0 and vectors Ym1, Ym2 are registered per device. The feature vector Ym0 represents that the device is turned off (set in the non-operational state), while the vectors Ym1, Ym2 represent that the device is turned on (in the operational state).

In the electricity usage condition determining process, the admittance vector time-series Y(n) of all devices that are used are observed at every moment. Accordingly to the current adding law, all the admittances are approximately similar to a sum of the admittance at each time of each device. Therefore, in the electricity usage condition determining process, distances are calculated between the observed admittance vectors and vectors in which a sum is calculated by variously changing the combinations of the registered (retained) feature vectors. A combination having the shortest distance is searched to estimate the operational state of each device.

Hereinafter, an operational state vector representing the operational state at each time (frame) of each device is denoted by D(n) = [d1, ..., dM] ("dm" represents any one of values of the operational state from 0, to C). Herein, "M" represents the quantity of the registered devices, "m" represents the number of the devices, and "n" represents the number of the frame.

In this occasion, a problem for estimating the operational state (usage condition) of each device based on the observed admittance vector time-series Y(n) can be described as a problem for solving D(n) (^) in the following Mathematical Formula 7. Note that "A" is a load matrix determined in advance. Simply, an identity matrix or some preset weighting matrices may be used as well.

[Mathematical Formula 6]

$$\hat{D}(n) = \underset{d_m = 0,...,C}{\arg\min} \ | A(Y(n) - \sum_{m=1}^{M} Y_{md_m}) |^2 \quad \cdots (7)$$

The combination calculating unit 107 and the comparing unit 108 function for the electricity usage condition determining process.

The combination calculating unit 107 calculates the combination patterns of the feature vectors of the plurality of electrical devices registered (retained) on the feature vector database 106. In other words, the combination calculating unit 107 calculates a sum of the feature vectors in each combination pattern.

The comparing unit 108 compares the feature vectors (sum of the feature vectors) combined by the combination calculating unit 107 with the admittance vector time-series Y(n) calculated by the admittance estimating unit 103. Then, the comparing unit 108 obtains an estimated result of the operational states (electricity usage condition) of the plurality of electrical devices. In other words, the comparing unit 108 determines D(n)(^) in the above-mentioned Mathematical Formula 7 in each frame n.

Herein, processes of the combination calculating unit 107 and the comparing unit 108 are different as hereinafter described, depending on the quantity of the devices.

"In A Case Of A Small Quantity of Devices"

In a case of a small quantity of devices, more specifically, in cases where the calculation in the above-mentioned Mathematical Formula 7 can be completed with respect to all operational state patterns that d1, ..., dM may take within the frame interval T, it is possible to carry out exhaustive search of a device state.

In this occasion, the combination calculating unit 107 calculates the sum of the feature vectors with respect to all the combination patters of d1, ..., dM, as shown in the following Mathematical Formula 8. The comparing unit 108 estimates the operational state (electricity usage condition) of each device in the present time n by searching D(n)(^) that maximizes the Mathematical Formula 7.

[Mathematical Formula 7]

$$\text{Sum of the feature vectors} = \sum_{m=1}^{M} Y_{md_m} \quad \cdots (8)$$

"In A Case Of A Large Quantity of Devices"

There are M-th power of (C + 1) ways for all the operational state patterns that d1, ..., dM may take, and the patterns exponentially increase when the quantity of the devices increases. Therefore, in a case of a large quantity of devices, it is practically difficult to search all within the finite frame interval T. Therefore, the combination calculating unit 107 takes a method that chooses, within a feasible range, stochastically possible combination patterns of the operational states based on the operational state (electricity usage condition), which is estimated at the present time, of each device.

An estimate value of the latest device state is represented by D(n-1). The combination calculating unit 107 calculates a predetermined I way of D(n) test patterns based on D(n-1), in the following order (1), (2), and (3).

(1) a pattern which does not change each elemental state of D(n-1)
(2) a pattern which changes X quantities or less of each elemental state of D(n-1)
(3) a pattern which sets each element of D(n-1) by random numbers in accordance with predetermined probability P(dmc)

The above-mentioned "I" and "X" are numbers that do not exceed numbers which can be calculated within the frame interval T. Further, the numbers of "I" and "X" are determined by a function of a calculator that is used practically. Further, the probability P(dmc) that generates the random numbers can be set by a method in which a histogram relating each state dmc of each device is obtained with respect to an estimate value D(n) of the device state in the past, and the histogram is normalized so that a sum becomes one. When practically using in a household, there occurs a deviation of the device usage condition depending on time and day. Therefore, it is effective to apply a method in which the above-mentioned histogram is aggregated according to day and time, and probability distribution is used by switching depending on the present time (day or time).

The combination calculating unit 107 calculates the sum of the feature vectors with respect to the above-mentioned I way of the combination patterns, as shown in the above-mentioned Mathematical Formula 8. The comparing unit 108 estimates the operational state (electricity usage condition) of each device in the present time n by searching D(n)(^) that maximizes the Mathematical Formula 7.

Fig. 7 is a view showing an integral process of an operational state estimating method in a case of a small quantity of devices. Fig. 8 is a view showing an integral process of the operational state estimating method in a case of a large quantity of devices.

Back to Fig. 1, the recording/display unit 109 records, on a recording medium, the estimated result of the operational state (electricity usage condition) of each device obtained by the comparing unit 108 together with time, and displays the same on a display. As a result, a history of the operational state of each device can be stored. Further, a user can easily grasp the present operational state (electricity usage condition) of each device. In such a case, not only the operational state (electricity usage condition) of each device, but also electricity usage may be recorded or displayed.

The electricity usage in an n-th frame of each device can be calculated from the following Mathematical Formula 9 by using the estimate value D(n)(^) = (d1, ..., dM) of each device state. Note that Ymdmk is an element corresponding to k-th harmonics of a feature vector Ymdm when an m-th device is in a dm state.

[Mathematical Formula 8]

$$P_m(n) = \sum_{k=1}^{K} Y_{md_m k} \, V_k{}^2(n) \quad \cdots (9)$$

Hereinafter, an operation of the above-mentioned operational state estimating apparatus 100 for the electrical device shown in Fig. 1 will be described. First, an operation in the device registration process will be described. In the current-voltage measuring unit 101, the current and voltage values at every moment are measured at one part of the base of the electrical power line. These measured values are supplied to the filtering unit 102. In the filtering unit 102, the signal components of the power frequency and the harmonics thereof are filtered from the time-series measured values of the current and voltage (see Mathematical Formulas 1 and 2).

The signal components filtered by the filtering unit 102 are supplied to the admittance calculating unit 103. In the admittance calculating unit 103, admittances Yk(n) of the present time n are calculated based on the signal components filtered by the filtering unit 102 (see Mathematical Formula 3). The admittance vector time-series Y(n) obtained by the admittance calculating unit 103 are supplied to the single admittance estimating unit 104.

In the single admittance estimating unit 104, based on the admittance vector time-series Y(n), the plurality of electrical devices (device A, device B, device C and the like) connected to the electrical power line is serially set as the target device. Herein, admittance vector time-series of the single target device are estimated. The admittance vector time-series of the single target device are supplied to the vector quantization unit 105.

In the vector quantization unit 105, the vector quantization is carried out so that the admittance vector time-series Y(n), throughout the N frame of each device, estimated by the single admittance estimating unit 104 are represented by the predetermined quantity C (C is sufficiently smaller than N) of the feature vectors. Further, in the vector quantization unit 105, the representative vector Ymc of each device is registered on the feature vector database 106.

Next, an operation in the electricity usage condition determining process will be described. In the current-voltage measuring unit 101, the current and voltage values at every moment are measured at one part of the base of the electrical power line. These measured values are supplied to the filtering unit 102. In the filtering unit 102, the signal components of the power frequency and the harmonics thereof are filtered from the time-series measured values of the current and voltage (see Mathematical Formulas 1 and 2).

The signal components filtered by the filtering unit 102 are supplied to the admittance calculating unit 103. In the admittance calculating unit 103, admittances Yk(n) of the present time n are calculated based on the signal components filtered by the filtering unit 102 (see Mathematical Formula 3). The admittance vector time-series Y(n) obtained by the admittance calculating unit 103 are supplied to the comparing unit 108.

In the combination calculating unit 107, the combination patterns, of the feature vectors of the plurality of electrical devices, which have been registered (retained) on the feature vector database 106 are calculated. In the comparing unit 108, the feature vectors (sum of the feature vectors) combined by the combination calculating unit 107 are compared with the admittance vector time-series Y(n) calculated by the admittance calculating unit 103. Then, the estimated result of the operational states (electricity usage condition) of the plurality of electrical devices is obtained (see Mathematical Formula 7).

The estimated result of the operational states (electricity usage condition) of the plurality of electrical devices obtained by the comparing unit 108 are supplied to the recording/display unit 109. In the recording/display unit 109, the estimated result of the operational state (electricity usage condition) of each device obtained by the comparing unit 108 is recorded together with the time, and is displayed on the display.

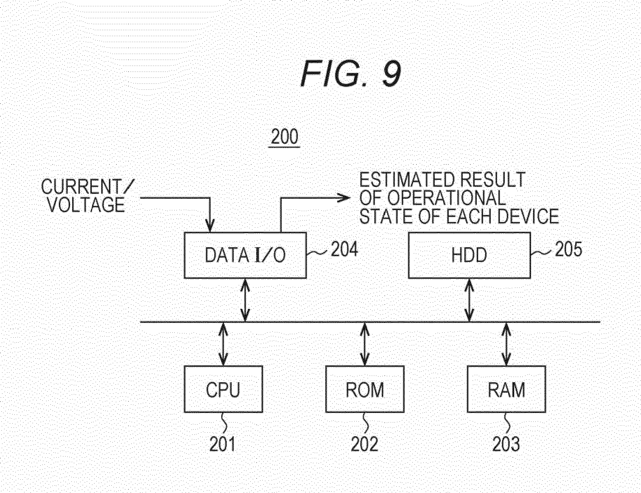

Note that the operational state estimating apparatus 100 shown in Fig. 1 may include hardware, and at least a part of the apparatus may include software. For example, a computer device 200 shown in Fig. 9 can be configured to function as each part in the operational state estimating apparatus 100 shown in Fig. 1, that is, from the filtering unit 102 to the comparing unit 108, so as to execute the device registration process and the electricity usage condition determining process similar to the above-mentioned processes.

The computer device 200 includes a central processing unit (CPU) 201, a random access memory (RAM) 202, a read only memory (ROM) 203, a data input/output unit (data I/O) 204, and a hard disk drive (HDD) 205. In the ROM 202, a processing program of the CPU 201 and the like are stored. The RAM 203 functions as a work area of the CPU 201. The CPU 201 reads out the processing program stored in the ROM 202, as necessary, and forwards the readout processing program to the RAM 203 to decompress the same. Then, the CPU 201 reads out the decompressed processing program to execute the processing.

In the computer device 200, the current and voltage of the time-series measured by the current-voltage measuring unit 101 are input through the data I/O 204 and are accumulated in the HDD 205. The CPU 201 executes the device registration process and the electricity usage condition determining process with respect to the time-series data of the current and voltage accumulated in the HDD 205. Then, the estimated result of the operational state of each device is output to outside through the data I/O 204.

As mentioned above, in the operational state estimating apparatus 100 for the electrical device shown in Fig. 1, the admittance vector time-series obtained based on the current and voltage measured by the electrical power line are compared with the combinations of the feature vectors of the plurality of electrical devices connected to the electrical power line. Then, the estimated result of the operational states of the plurality of electrical devices is obtained. Accordingly, it is possible to appropriately estimate the operational states (electricity usage condition) of the plurality of electrical devices. Further, the operational state (electricity usage condition) of each device in a household can be easily visualized, and electricity can be effectively saved. Moreover, it is possible to grasp the electricity usage condition of each electrical device in a household, and to supply electricity flexibly.

<2. Second Embodiment>

[Operational State Estimating System For Electrical Device]

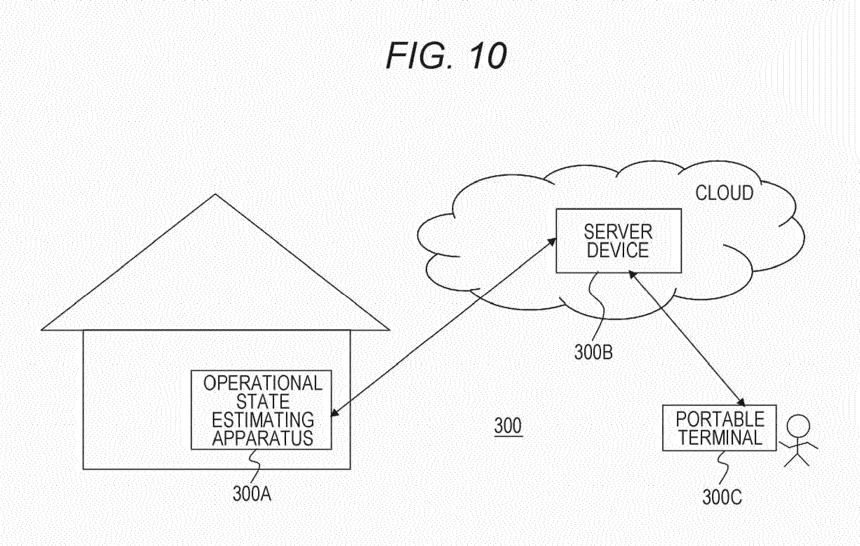

Fig. 10 is a view showing an exemplary configuration of an operational state estimating system 300 for an electrical device as a second embodiment of the present technology. This operational state estimating system 300 includes an operational state estimating apparatus 300A for an electrical device disposed in a household, a server device 300B in cloud, and a portable terminal 300C.

In the operational state estimating system 300, the server device 300B estimates the operational states of a plurality of electrical devices connected to an electrical power line from admittance vector time-series. Therefore, the operational state estimating apparatus 300A transmits admittance vector time-series Y(n) to the server device 300B, and receives an estimated result of the operational state (electricity usage condition) of each device from the server device 300B.

Further, the operational state estimating system 300 can carry out request-to-send of the estimated result of the operational state of the plurality of electrical devices to the server device 300B from the portable terminal 300C, that is, another terminal device different from the operational state estimating apparatus 300A. This portable terminal 300C receives the estimated result, and is capable of, for example, displaying the same.

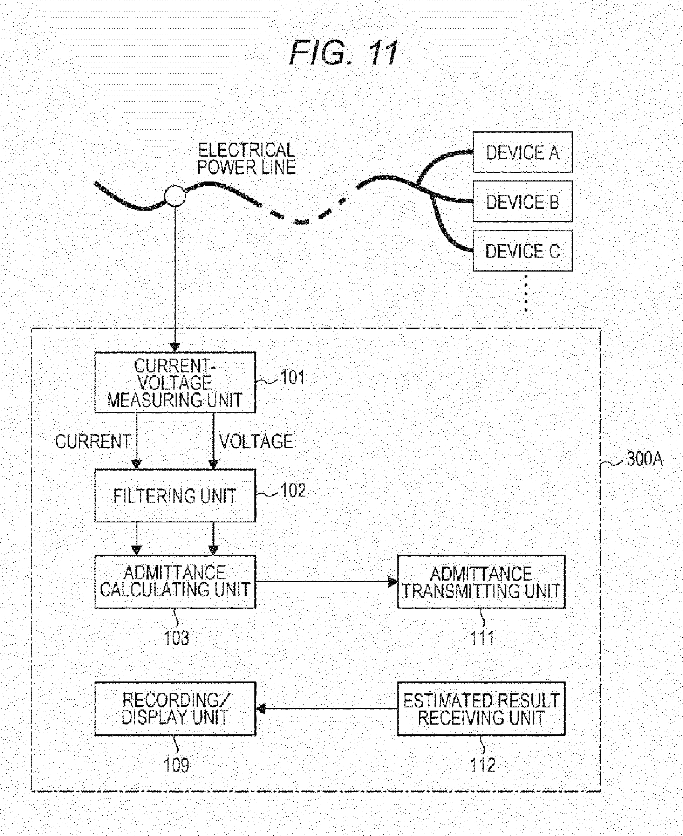

Fig. 11 is a view showing an exemplary configuration of the operational state estimating apparatus 300A. In Fig. 11, the same components as those shown in Fig. 1 are denoted by the same reference numerals as those used in Fig. 1, and explanation of them is not repeated herein. This operational state estimating apparatus 300A includes a current-voltage measuring unit 101, a filtering unit 102, an admittance calculating unit 103, an admittance transmitting unit 111, an estimated result receiving unit 112, and a recording/display unit 109.

The admittance transmitting unit 111 transmits the admittance vector time-series Y (n) obtained by the admittance calculating unit 103 to the server device 300B in the cloud. The estimated result receiving unit 112 receives the estimated result of the operational state (electricity usage condition) of each electrical device transmitted from the server device 300B in the cloud. Then, the estimated result receiving unit 112 supplies the estimated result to the recording/display unit 109.

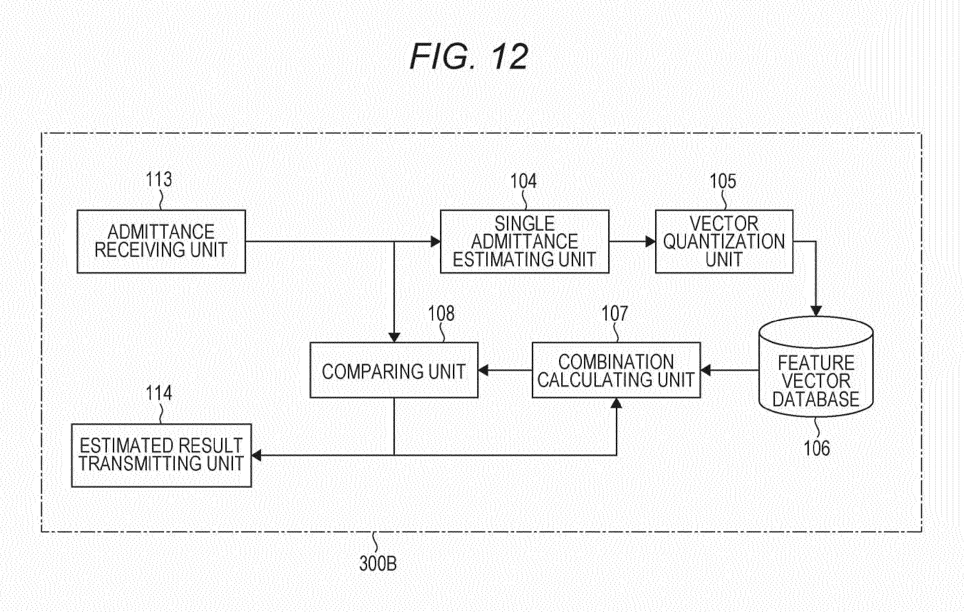

Fig. 12 is a view showing an exemplary configuration of the server device 300B. In Fig. 12, the same components as those shown in Fig. 1 are denoted by the same reference numerals as those used in Fig. 1, and explanation of them is not repeated herein. This server device 300B includes an admittance receiving unit 113, a single admittance estimating unit 104, a vector quantization unit 105, a feature vector database 106, a combination calculating unit 107, a comparing unit 108, and an estimated result transmitting unit 114.

The admittance receiving unit 113 receives the admittance vector time-series Y(n) transmitted from the operational state estimating apparatus 300A. Then, the admittance receiving unit 113 supplies the admittance vector time-series Y(n) to the single admittance estimating unit 104 and the comparing unit 108. The estimated result transmitting unit 114 transmits the estimated result of the operational state (electricity usage condition) of each electrical device obtained by the comparing unit 108 to the operational state estimating apparatus 300A.

Although detailed description will be omitted, the operational state estimating system 300 for the electrical device shown in Fig. 10 executes the device registration process and the electricity usage condition determining process in a similar way as the operational state estimating apparatus 100 for the electrical device shown in Fig. 1. Accordingly, it is possible to appropriately estimate the operational states of the plurality of electrical devices, that is, the electricity usage condition.

Further, in the operational state estimating system 300 for the electrical device shown in Fig. 10, instead of the operational state estimating apparatus 300A, the server device 300B in the cloud carries out a process of estimating the operational states (electricity usage condition) of the plurality of electrical devices connected to the electrical power line from the admittance vector time-series Y(n). Accordingly, it is possible to reduce a processing load of the operational state estimating apparatus 300A, and also to provide the estimated result from the server device 300B to the operational state estimating apparatus 300A with high accuracy due to a high-performance process.

Further, in the operational state estimating system 300 for the electrical device shown in Fig. 10, the request-to-send of the estimated result can be transmitted from portable terminal 300C to the server device 300B, and the estimated result can be received. Accordingly, it is possible for a user to confirm the estimated result of the operational states of the plurality of electrical devices even from the place where he/she is, by using the portable terminal 300C but not the fixed operational state estimating apparatus 300A.

<3. Modifications>

In the above-mentioned embodiments, the examples with executive functions of both the device registration process and the electricity usage condition determining process have been described. However, for example, an example with only the executive function of the electricity usage condition determining process can also be taken into consideration. In such a case, the feature vector of each device is registered and retained in the feature vector database 106 by some method. Similarly, the following numbered clauses describe further, unclaimed matter;

Clause 1. The operational state estimating apparatus for the electrical device according to claim 4, wherein the predetermined probability distribution is calculated from past histories of the operational states of the plurality of electrical devices.

Clause 2. The operational state estimating apparatus for the electrical device according to claim 4, wherein the predetermined probability distribution is one that is selected according to time from a plurality of probability distributions calculated according to day and time.

Clause 3. The operational state estimating apparatus for the electrical device according to claim 1, wherein the comparing unit calculates inter-vector distances between the combined feature vectors and the calculated admittance vector time-series, and sets a combination having the shortest distance as the estimated result of the operational states of the plurality of electrical devices.

Clause 4. The feature vector registering apparatus for the electrical device according to claim 7, wherein the feature vector extracting unit extracts one or a plurality of feature vectors, as a feature vector of a predetermined electrical device, from the calculated admittance vector time-series by vector quantization.

Clause 5. The server device according to claim 14, further comprising a request-to-send receiving unit configured to receive a request-to-send of the estimated result transmitted from another terminal device different from the terminal device, wherein the estimated result transmitting unit transmits the obtained estimated result of the operational states of the plurality of electrical devices to the other terminal device based on the received request-to-send.

REFERENCE SIGNS LIST

100 Operational state estimating apparatus for an electrical device
101 Current-voltage measuring unit
102 Filtering unit
103 Admittance calculating unit
104 Single admittance estimating unit
105 Vector quantization unit
106 Feature vector database
107 Combination calculating unit
108 Comparing unit
109 Recording/display unit
111 Admittance transmitting unit
112 Estimated result receiving unit
113 Admittance receiving unit
114 Estimated result transmitting unit
200 Computer device
201 CPU
202 ROM
203 RAM
204 Data I/O
205 HDD
300 Operational state estimating system for an electrical device
300A Operational state estimating apparatus for an electrical device
300B Server device
300C Portable terminal

## Claims

1. An operational state estimating apparatus (100) for an electrical device, comprising:

   a current-voltage measuring unit (101) configured to measure current and voltage as time-series from an electrical power line to which a plurality of electrical devices is connected;
   a filtering unit (102) configured to filter signal components of power frequency and harmonics thereof from the time-series of the measured current and voltage;
   an admittance calculating unit (103) configured to calculate admittance vector time-series from both the filtered power frequency and harmonics, the admittance vector time-series including admittances of both the power frequency and harmonics thereof;
   a feature vector retaining unit (106) configured to retain feature vectors of the plurality of electrical devices;
   a combination calculating unit (107) configured to calculate combination patterns of the retained feature vectors of the plurality of electrical devices; and

a comparing unit (108) configured to compare the combined feature vectors and the calculated admittance vector time-series to obtain an estimated result of the operational states of the plurality of electrical devices.

2.  The operational state estimating apparatus for the electrical device according to claim 1, wherein the feature vector of a predetermined electrical device includes one or a plurality of feature vectors extracted by vector quantization from the admittance vector time-series in a case where the predetermined electrical device is in the operational state.

3.  The operational state estimating apparatus for the electrical device according to claim 1, wherein the combination calculating unit calculates all the combination patterns of the retained feature vectors.

4.  The operational state estimating apparatus for the electrical device according to claim 1, wherein the combination calculating unit calculates combination patterns, in which the operational states of the devices have been stochastically changed, from an estimated result of the latest device operational state based on combination patterns in which the operational states of the devices within a predetermined quantity have been changed and/or based on a predetermined probability distribution.

5.  An operational state estimating method for an electrical device, comprising:

    a current/voltage measuring step for measuring current and voltage as time-series from an electrical power line to which a plurality of electrical devices is connected;
    a filtering step for filtering signal components of power frequency and harmonics thereof from the time-series of the measured current and voltage;
    an admittance calculating step for calculating admittance vector time-series from both the filtered power frequency and harmonics, the admittance vector time-series including admittances of both the power frequency and harmonics thereof;
    a combination calculating step for calculating combination patterns of retained feature vectors of the plurality of electrical devices; and
    a comparing step for comparing the combined feature vectors and the calculated admittance vector time-series to obtain an estimated result of the operational states of the plurality of electrical devices.

6.  A program that makes a computer function as:

    a filtering means for filtering signal components of power frequency and harmonics thereof from time-series of current and voltage measured from an electrical power line to which a plurality of electrical devices is connected;
    an admittance calculating means for calculating admittance vector time-series from both the filtered power frequency and harmonics, the admittance vector time-series including admittances of both the power frequency and harmonics thereof;
    a feature vector retaining means for retaining feature vectors of the plurality of electrical devices;
    a combination calculating means for calculating combination patterns of the retained feature vectors of the plurality of electrical devices; and
    a comparing means comparing the combined feature vectors and the calculated admittance vector time-series to obtain an estimated result of the operational states of the plurality of electrical devices.

7.  A feature vector registering apparatus (100) for an electrical device, comprising:

    a current-voltage measuring unit (101) configured to measure current and voltage as time-series from an electrical power line to which a plurality of electrical devices is connected;
    a filtering unit (102) configured to filter signal components of power frequency and harmonics thereof from the time-series of the measured current and voltage;
    an admittance calculating unit (103) configured to calculate admittance vector time-series from both the filtered power frequency and harmonics, the admittance vector time-series including admittances of both the power frequency and harmonics thereof;
    a feature vector extracting unit (104) configured to extract feature vectors of each of the plurality of electrical devices from the calculated admittance vector time-series; and
    a feature vector registering unit (105) configured to register, on a database (106), the extracted feature vectors of the plurality of electrical devices.

8.  The feature vector registering apparatus for the electrical device according to claim 7, wherein the feature vector extracting unit estimates admittance vector time-series of a predetermined electrical device from the calculated admittance vector time-series, and extracts one or a plurality of feature vectors, as a feature vector of the predetermined electrical device, from the estimated admittance vector time-series by vector quantization.

9. The feature vector registering apparatus for the electrical device according to claim 8, wherein the feature vector extracting unit estimates admittance vector time-series of an electrical device other than the predetermined electrical device from the calculated admittance vector time-series in a case where the predetermined electrical device is not in an operational state, and estimates the admittance vector time-series of the predetermined electrical device from the calculated admittance vector time-series in a case where the predetermined electrical device is in the operational state by removing an estimate value of the estimated admittance vector time-series of the electrical device other than the predetermined electrical device.

10. The feature vector registering apparatus for the electrical device according to claim 9, wherein the feature vector extracting unit estimates the admittance vector time-series of the electrical device other than the predetermined electrical device by according and compositing phases of the calculated admittance vector time-series in time periods before and after driving the predetermined electrical device so that a correlation value of the admittance vector time-series becomes the highest.

11. A feature vector registering method for an electrical device, comprising:

    a current-voltage measuring step for measuring current and voltage as time-series from an electrical power line to which a plurality of electrical devices is connected;
    a filtering step for filtering signal components of power frequency and harmonics thereof from the time-series of the measured current and voltage;
    an admittance calculating step for calculating admittance vector time-series from both the filtered power frequency and harmonics, the admittance vector time-series including admittances of both the power frequency and harmonics thereof;
    a feature vector extracting step for extracting feature vectors of each of the plurality of electrical devices from the calculated admittance vector time-series; and
    a feature vector registering step for registering, on a database, the extracted feature vectors of the plurality of electrical devices.

12. The operational state estimating apparatus for the electrical device according to claim 1, comprising:
    a feature vector extracting unit configured to extract feature vectors of each of the plurality of electrical devices from the calculated admittance vector time-seriesr

13. An operational state estimating apparatus (300A) for an electrical device, comprising:

    a current-voltage measuring unit (101) configured to measure current and voltage as time-series from an electrical power line to which a plurality of electrical devices is connected;
    a filtering unit (102) configured to filter signal components of power frequency and harmonics thereof from the time-series of the measured current and voltage;
    an admittance calculating unit (103) configured to calculate admittance vector time-series from both the filtered power frequency and harmonics, the admittance vector time-series including admittances of both the power frequency and harmonics thereof;
    an admittance transmitting unit (111) configured to transmit the calculated admittance vector time-series to a server device (300B); and
    an estimated result receiving unit (112) configured to receive an estimated result of the operational states of the plurality of electrical devices from the server device (300B).

14. A server device (3008), comprising:

    an admittance receiving unit (113) configured to receive admittance vector time-series transmitted from an operational state estimating apparatus (300A), the admittance vector time-series including admittances of both the power frequency and harmonics thereof;
    a feature vector retaining unit (106) configured to retain feature vectors of a plurality of electrical devices;
    a combination calculating unit (107) configured to calculate combination patterns of the retained feature vectors of the plurality of electrical devices;

a comparing unit (108) configured to compare the combined feature vectors and the received admittance vector time-series to obtain an estimated result of the operational states of the plurality of electrical devices; and an estimated result transmitting unit (114) configured to transmit the obtained estimated result of the operational states of the plurality of electrical devices to the an operational state estimating apparatus (300A).

15. An operational state estimating system (300) for an electrical device comprising the operational state estimating apparatus (300A) of claim 13 and the server device (300B) of claim 14.

**Patentansprüche**

1. Betriebszustandsschätzvorrichtung (100) für eine elektrische Einrichtung, die Folgendes umfasst:

eine Strom-/Spannungs-Messeinheit (101), die konfiguriert ist, einen Strom und eine Spannung einer elektrischen Stromleitung, mit der mehrere elektrische Einrichtungen verbunden sind, als Zeitreihen zu messen;
eine Filtereinheit (102), die konfiguriert ist, Signalkomponenten der Netzfrequenz und ihrer Harmonischen aus den Zeitreihen des gemessenen Stroms und der gemessenen Spannung herauszufiltern;
eine Admittanzberechnungseinheit (103), die konfiguriert ist, eine Admittanzvektorzeitreihe sowohl der gefilterten Netzfrequenz als auch ihrer Harmonischen zu berechnen, wobei die Admittanzvektorzeitreihe Admittanzen sowohl der Netzfrequenz als auch ihrer Harmonischen enthält;
eine Merkmalsvektor-Halteeinheit (106), die konfiguriert ist, Merkmalsvektoren der mehreren elektrischen Einrichtungen festzuhalten;
eine Kombinationsberechnungseinheit (107), die konfiguriert ist, Kombinationsmuster der festgehaltenen Merkmalsvektoren der mehreren elektrischen Einrichtungen zu berechnen; und
eine Vergleichseinheit (108), die konfiguriert ist, die kombinierten Merkmalsvektoren und die berechneten Admittanzvektorzeitreihen zu vergleichen, um ein Schätzergebnis der Betriebszustände der mehreren elektrischen Einrichtungen zu erhalten.

2. Betriebszustandsschätzvorrichtung für die elektrische Einrichtung nach Anspruch 1, wobei der Merkmalsvektor einer vorgegebenen elektrischen Einrichtung einen oder mehrere Merkmalsvektoren enthält, die durch eine Vektorquantisierung aus den Admittanzvektorzeitreihen extrahiert werden, wenn sich das vorgegebene elektrische Einrichtung im Betriebszustand befindet.

3. Betriebszustandsschätzvorrichtung für die elektrische Einrichtung nach Anspruch 1, wobei die Kombinationsberechnungseinheit alle Kombinationsmuster der festgehaltenen Merkmalsvektoren berechnet.

4. Betriebszustandsschätzvorrichtung für die elektrische Einrichtung nach Anspruch 1, wobei die Kombinationsberechnungseinheit Kombinationsmuster berechnet, in denen die Betriebszustände der Einrichtungen von einem Schätzergebnis des jüngsten Einrichtungsbetriebszustands auf der Grundlage von Kombinationsmustern, in denen die Betriebszustände der Einrichtungen in einer vorgegebenen Größe geändert worden sind, und/oder auf der Grundlage einer vorgegebenen Wahrscheinlichkeitsverteilung stochastisch geändert worden sind.

5. Betriebszustandsschätzverfahren für eine elektrische Einrichtung, das Folgendes umfasst:

einen Strom-/Spannungs-Messschritt zum Messen eines Stroms und einer Spannung einer elektrischen Stromleitung, mit der mehrere elektrische Einrichtungen verbunden sind, als Zeitreihen;
einen Filterschritt zum Filtern von Signalkomponenten der Netzfrequenz und ihrer Harmonischen aus den Zeitreihen des gemessenen Stroms und der gemessenen Spannung;
einen Admittanzberechnungsschritt zum Berechnen einer Admittanzvektorzeitreihe sowohl der gefilterten Netzfrequenz als auch ihrer Harmonischen, wobei die Admittanzvektorzeitreihe Admittanzen sowohl der Netzfrequenz als auch ihrer Harmonischen enthält;
einen Kombinationsberechnungsschritt zum Berechnen von Kombinationsmustern der festgehaltenen Merkmalsvektoren der mehreren elektrischen Einrichtungen und
einen Vergleichsschritt zum Vergleichen der kombinierten Merkmalsvektoren und der berechneten Admittanzvektorzeitreihen, um ein Schätzergebnis der Betriebszustände der mehreren elektrischen Einrichtungen zu erhalten.

6. Programm, das einen Computer veranlasst, wie folgt zu arbeiten:

als ein Filtermittel zum Filtern von Signalkomponenten der Netzfrequenz und ihrer Harmonischen aus den Zeitreihen des gemessenen Stroms und der gemessenen Spannung einer elektrischen Stromleitung, mit der mehrere elektrische Einrichtungen verbunden sind;

als ein Admittanzberechnungsmittel zum Berechnen einer Admittanzvektorzeitreihe sowohl der gefilterten Netzfrequenz als auch ihrer Harmonischen, wobei die Admittanzvektorzeitreihe Admittanzen sowohl der Netzfrequenz als auch ihrer Harmonischen enthält;

als ein Merkmalsvektor-Haltemittel zum Festhalten von Merkmalsvektoren der mehreren elektrischen Einrichtungen;

als ein Kombinationsberechnungsmittel zum Berechnen von Kombinationsmustern der festgehaltenen Merkmalsvektoren der mehreren elektrischen Einrichtungen und

als ein Vergleichsmittel, das die kombinierten Merkmalsvektoren und die berechneten Admittanzvektorzeitreihen vergleicht, um ein Schätzergebnis der Betriebszustände der mehreren elektrischen Einrichtungen zu erhalten.

7. Merkmalsvektor-Registrierungsvorrichtung (100) für eine elektrische Einrichtung, die Folgendes umfasst:

eine Strom-/Spannungs-Messeinheit (101), die konfiguriert ist, einen Strom und eine Spannung einer elektrischen Stromleitung, mit der mehrere elektrische Einrichtungen verbunden sind, als Zeitreihen zu messen;
eine Filtereinheit (102), die konfiguriert ist, Signalkomponenten der Netzfrequenz und ihrer Harmonischen aus den Zeitreihen des gemessenen Stroms und der gemessenen Spannung herauszufiltern;
eine Admittanzberechnungseinheit (103), die konfiguriert ist, eine Admittanzvektorzeitreihe sowohl der gefilterten Netzfrequenz als auch ihrer Harmonischen zu berechnen, wobei die Admittanzvektorzeitreihe Admittanzen sowohl der Netzfrequenz als auch ihrer Harmonischen enthält;
eine Merkmalsvektorextraktionseinheit (104), die konfiguriert ist, Merkmalsvektoren jeder der mehreren elektrischen Einrichtungen aus den berechneten Admittanzvektorzeitreihen zu extrahieren; und
eine Merkmalsvektorregistrierungseinheit (105), die konfiguriert ist, die extrahierten Merkmalsvektoren der mehreren elektrischen Einrichtungen in einer Datenbank (106) zu registrieren.

8. Merkmalsvektorregistrierungsvorrichtung für die elektrische Einrichtung nach Anspruch 7, wobei die Merkmalsvektorextraktionseinheit Admittanzvektorzeitreihen einer vorgegebenen elektrischen Einrichtung aus den berechneten Admittanzvektorzeitreihen schätzt und einen oder mehrere Merkmalsvektoren als einen Merkmalsvektor der vorgegebenen elektrischen Einrichtung aus den geschätzten Admittanzvektorzeitreihen durch Vektorquantisierung extrahiert.

9. Merkmalsvektorregistrierungsvorrichtung für die elektrische Einrichtung nach Anspruch 8, wobei die Merkmalsvektorextraktionseinheit Admittanzvektorzeitreihen einer elektrischen Einrichtung außer der vorgegebenen elektrischen Einrichtung aus den berechneten Admittanzvektorzeitreihen schätzt, wenn sich die vorgegebene elektrische Einrichtung nicht in einem Betriebszustand befindet, und die Admittanzvektorzeitreihen der vorgegebenen elektrischen Einrichtung aus den berechneten Admittanzvektorzeitreihen schätzt, wenn sich die vorgegebene elektrische Einrichtung im Betriebszustand befindet, indem ein Schätzwert der geschätzten Admittanzvektorzeitreihen der elektrischen Einrichtung außer der vorgegebenen elektrischen Einrichtung entfernt wird.

10. Merkmalsvektorregistrierungsvorrichtung für die elektrische Einrichtung nach Anspruch 9, wobei die Merkmalsvektorextraktionseinheit Admittanzvektorzeitreihen der elektrischen Einrichtung außer der vorgegebenen elektrischen Einrichtung durch Zugstehen und Zusammensetzen von Phasen der berechneten Admittanzvektorzeitreihen in Zeiträumen vor und nach dem Ansteuern der vorgegebenen elektrischen Einrichtung derart, dass ein Korrelationswert der Admittanzvektorzeitreihe am höchsten ist.

11. Merkmalsvektorregistrierungsverfahren für eine elektrische Einrichtung, das Folgendes umfasst:

einen Strom-/Spannungsmessschritt zum Messen eines Stroms und einer Spannung einer elektrischen Stromleitung, mit der mehrere elektrische Einrichtungen verbunden sind, als Zeitreihen;
einen Filterschritt zum Filtern von Signalkomponenten der Netzfrequenz und ihrer Harmonischen aus den Zeitreihen des gemessenen Stroms und der gemessenen Spannung;
einen Admittanzberechnungsschritt zum Berechnen einer Admittanzvektorzeitreihe sowohl der gefilterten Netzfrequenz als auch ihrer Harmonischen, wobei die Admittanzvektorzeitreihe Admittanzen sowohl der Netzfrequenz als auch ihrer Harmonischen enthält;
einen Merkmalsvektorextraktionsschritt zum Extrahieren von Merkmalsvektoren jeder der mehreren elektrischen Einrichtungen aus den berechneten Admittanzvektorzeitreihen;

einen Merkmalsvektorregistrierungsschritt zum Registrieren der extrahierten Merkmalsvektoren der mehreren elektrischen Einrichtungen in einer Datenbank.

**12.** Betriebszustandsschätzvorrichtung für die elektrische Einrichtung nach Anspruch 1, die Folgendes umfasst:
eine Merkmalsvektorextraktionseinheit, die konfiguriert ist, Merkmalsvektoren jeder der mehreren elektrischen Einrichtungen aus den berechneten Admittanzvektorzeitreihen zu extrahieren.

**13.** Betriebszustandsschätzvorrichtung (300A) für eine elektrische Einrichtung, die Folgendes umfasst:

eine Strom-/Spannungs-Messeinheit (101), die konfiguriert ist, einen Strom und eine Spannung einer elektrischen Stromleitung, mit der mehrere elektrische Einrichtungen verbunden sind, als Zeitreihen zu messen;
eine Filtereinheit (102), die konfiguriert ist, Signalkomponenten der Netzfrequenz und ihrer Harmonischen aus den Zeitreihen des gemessenen Stroms und der gemessenen Spannung herauszufiltern;
eine Admittanzberechnungseinheit (103), die konfiguriert ist, eine Admittanzvektorzeitreihe sowohl der gefilterten Netzfrequenz als auch ihrer Harmonischen zu berechnen, wobei die Admittanzvektorzeitreihe Admittanzen sowohl der Netzfrequenz als auch ihrer Harmonischen enthält;
eine Admittanzsendeeinheit (111), die konfiguriert ist, die berechnete Admittanzvektorzeitreihe zu einer Servereinrichtung (300B) zu übertragen; und
eine Schätzergebnisempfangseinheit (112), die konfiguriert ist, ein Schätzergebnis der Betriebszustände der mehreren elektrischen Einrichtungen von der Server-Einrichtung (300B).

**14.** Servereinrichtung (300B), die Folgendes umfasst:

eine Admittanzempfangseinheit (113), die konfiguriert ist, eine Admittanzvektorzeitreihe, die von einer Betriebszustandsschätzvorrichtung (300A) gesendet wurde, zu empfangen, wobei die Admittanzvektorzeitreihe Admittanzen sowohl der Netzfrequenz als auch ihrer Harmonischen enthält;
eine Merkmalsvektor-Halteeinheit (106), die konfiguriert ist, Merkmalsvektoren von mehreren elektrischen Einrichtungen festzuhalten;
eine Kombinationsberechnungseinheit (107), die konfiguriert ist, Kombinationsmuster der festgehaltenen Merkmalsvektoren der mehreren elektrischen Einrichtungen zu berechnen;
eine Vergleichseinheit (108), die konfiguriert ist, die kombinierten Merkmalsvektoren und die berechneten Admittanzvektorzeitreihen zu vergleichen, um ein Schätzergebnis der Betriebszustände der mehreren elektrischen Einrichtungen zu erhalten; und
eine Schätzergebnissendeeinheit (114), die konfiguriert ist, das erhaltene Schätzergebnis der Betriebszustände der mehreren elektrischen Einrichtungen zur Schätzvorrichtungen (300A) eines Betriebszustands zu senden.

**15.** Betriebszustandsschätzsystem (300) für eine elektrische Einrichtung, das die Betriebszustandsschätzvorrichtung (300A) nach Anspruch 13 und die Servereinrichtung (300B) nach Anspruch 14 umfasst.

**Revendications**

**1.** Appareil (100) d'estimation d'états de fonctionnement pour un dispositif électrique, comprenant :

une unité de mesure de courant-tension (101) configurée pour mesurer un courant et une tension sous forme de séries temporelles à partir d'une ligne d'alimentation électrique à laquelle est reliée une pluralité de dispositifs électriques ;
une unité de filtrage (102) configurée pour filtrer des composantes de signal d'une fréquence d'alimentation et de ses harmoniques à partir des séries temporelles du courant et de la tension mesurés ;
une unité de calcul d'admittances (103) configurée pour calculer des séries temporelles de vecteurs d'admittances à partir à la fois de la fréquence d'alimentation et des harmoniques filtrés, les séries temporelles de vecteurs d'admittances comportant des admittances à la fois de la fréquence d'alimentation et de ses harmoniques ;
une unité de stockage de vecteurs de caractéristiques (106) configurée pour stocker des vecteurs de caractéristiques de la pluralité de dispositifs électriques ;
une unité de calcul de combinaisons (107) configurée pour calculer des modèles de combinaisons des vecteurs de caractéristiques stockés de la pluralité de dispositifs électriques ; et
une unité de comparaison (108) configurée pour comparer les vecteurs de caractéristiques combinés et les séries temporelles de vecteurs d'admittances calculées dans le but d'obtenir un résultat estimé des états de fonctionnement de la pluralité de dispositifs électriques.

2. Appareil d'estimation d'états de fonctionnement pour le dispositif électrique selon la revendication 1, dans lequel le vecteur de caractéristiques d'un dispositif électrique prédéterminé comporte un ou une pluralité de vecteurs de caractéristiques extraits par quantification vectorielle à partir des séries temporelles de vecteurs d'admittances dans le cas où le dispositif électrique prédéterminé occupe l'état de fonctionnement.

3. Appareil d'estimation d'états de fonctionnement pour le dispositif électrique selon la revendication 1, dans lequel l'unité de calcul de combinaisons calcule tous les modèles de combinaisons des vecteurs de caractéristiques stockés.

4. Appareil d'estimation d'états de fonctionnement pour le dispositif électrique selon la revendication 1, dans lequel l'unité de calcul de combinaisons calcule des modèles de combinaisons, dans lesquels les états de fonctionnement des dispositifs ont été modifiés de manière stochastique, à partir d'un résultat estimé du plus récent état de fonctionnement des dispositifs sur la base de modèles de combinaisons dans lesquels les états de fonctionnement des dispositifs dans les limites d'une quantité prédéterminée ont été modifiés et/ou sur la base d'une distribution de probabilités prédéterminée.

5. Procédé d'estimation d'états de fonctionnement pour un dispositif électrique, comprenant :

une étape de mesure de courant/tension consistant à mesurer un courant et une tension sous forme de séries temporelles à partir d'une ligne d'alimentation électrique à laquelle est reliée une pluralité de dispositifs électriques ;
une étape de filtrage consistant à filtrer des composantes de signal d'une fréquence d'alimentation et de ses harmoniques à partir des séries temporelles du courant et de la tension mesurés ;
une étape de calcul d'admittances consistant à calculer des séries temporelles de vecteurs d'admittances à partir à la fois de la fréquence d'alimentation et des harmoniques filtrés, les séries temporelles de vecteurs d'admittances comportant des admittances à la fois de la fréquence d'alimentation et de ses harmoniques ;
une étape de calcul de combinaisons consistant à calculer des modèles de combinaisons des vecteurs de caractéristiques stockés de la pluralité de dispositifs électriques ; et
une étape de comparaison consistant à comparer les vecteurs de caractéristiques combinés et les séries temporelles de vecteurs d'admittances calculées dans le but d'obtenir un résultat estimé des états de fonctionnement de la pluralité de dispositifs électriques.

6. Programme qui fait en sorte qu'un ordinateur fonctionne comme :

un moyen de filtrage destiné à filtrer des composantes de signal d'une fréquence d'alimentation et de ses harmoniques à partir des séries temporelles d'un courant et d'une tension mesurés à partir d'une ligne d'alimentation électrique à laquelle est reliée une pluralité de dispositifs électriques ;
un moyen de calcul d'admittances destiné à calculer des séries temporelles de vecteurs d'admittances à partir à la fois de la fréquence d'alimentation et des harmoniques filtrés, les séries temporelles de vecteurs d'admittances comportant des admittances à la fois de la fréquence d'alimentation et de ses harmoniques ;
un moyen de stockage de vecteurs de caractéristiques destiné à stocker des vecteurs de caractéristiques de la pluralité de dispositifs électriques ;
un moyen de calcul de combinaisons destiné à calculer des modèles de combinaisons des vecteurs de caractéristiques stockés de la pluralité de dispositifs électriques ; et
un moyen de comparaison destiné à comparer les vecteurs de caractéristiques combinés et les séries temporelles de vecteurs d'admittances calculées dans le but d'obtenir un résultat estimé des états de fonctionnement de la pluralité de dispositifs électriques.

7. Appareil (100) d'enregistrement de vecteurs de caractéristiques pour un dispositif électrique, comprenant :

une unité de mesure de courant-tension (101) configurée pour mesurer un courant et une tension sous forme de séries temporelles à partir d'une ligne d'alimentation électrique à laquelle est reliée une pluralité de dispositifs électriques ;
une unité de filtrage (102) configurée pour filtrer des composantes de signal d'une fréquence d'alimentation et de ses harmoniques à partir des séries temporelles du courant et de la tension mesurés ;
une unité de calcul d'admittances (103) configurée pour calculer des séries temporelles de vecteurs d'admittances à partir à la fois de la fréquence d'alimentation et des harmoniques filtrés, les séries temporelles de vecteurs d'admittances comportant des admittances à la fois de la fréquence d'alimentation et de ses harmoniques ;

une unité d'extraction de vecteurs de caractéristiques (104) configurée pour extraire des vecteurs de caractéristiques de chacun de la pluralité de dispositifs électriques à partir des séries temporelles de vecteurs d'admittances calculées ; et

une unité d'enregistrement de vecteurs de caractéristiques (105) configurée pour enregistrer, sur une base de données (106), les vecteurs de caractéristiques extraits de la pluralité de dispositifs électriques.

8. Appareil d'enregistrement de vecteurs de caractéristiques pour le dispositif électrique selon la revendication 7, dans lequel l'unité d'extraction de vecteurs de caractéristiques estime des séries temporelles de vecteurs d'admittances d'un dispositif électrique prédéterminé à partir de séries temporelles de vecteurs d'admittances calculées, et extrait un ou une pluralité de vecteurs de caractéristiques, comme vecteur de caractéristiques du dispositif électrique prédéterminé, à partir des séries temporelles de vecteurs d'admittances estimées par quantification vectorielle.

9. Appareil d'enregistrement de vecteurs de caractéristiques pour le dispositif électrique selon la revendication 8, dans lequel l'unité d'extraction de vecteurs de caractéristiques estime des séries temporelles de vecteurs d'admittances d'un dispositif électrique autre que le dispositif électrique prédéterminé à partir de séries temporelles de vecteurs d'admittances calculées dans le cas où le dispositif électrique prédéterminé n'occupe pas un état de fonctionnement, et estime les séries temporelles de vecteurs d'admittances du dispositif électrique prédéterminé à partir des séries temporelles de vecteurs d'admittances calculées dans le cas où le dispositif électrique prédéterminé occupe l'état de fonctionnement par suppression d'une valeur d'estimation des séries temporelles de vecteurs d'admittances estimées du dispositif électrique autre que le dispositif électrique prédéterminé.

10. Appareil d'enregistrement de vecteurs de caractéristiques pour le dispositif électrique selon la revendication 9, dans lequel l'unité d'extraction de vecteurs de caractéristiques estime les séries temporelles de vecteurs d'admittances du dispositif électrique autre que le dispositif électrique prédéterminé par accord et composition de phases des séries temporelles de vecteurs d'admittances calculées dans des périodes de temps qui précèdent et qui suivent la commande du dispositif électrique prédéterminé de façon à rendre maximale une valeur de corrélation des séries temporelles de vecteurs d'admittances.

11. Procédé d'enregistrement de vecteurs de caractéristiques pour un dispositif électrique, comprenant :

une étape de mesure de courant-tension consistant à mesurer un courant et une tension sous forme de séries temporelles à partir d'une ligne d'alimentation électrique à laquelle est reliée une pluralité de dispositifs électriques ;

une étape de filtrage consistant à filtrer des composantes de signal d'une fréquence d'alimentation et de ses harmoniques à partir des séries temporelles du courant et de la tension mesurés ;

une étape de calcul d'admittances consistant à calculer des séries temporelles de vecteurs d'admittances à partir à la fois de la fréquence d'alimentation et des harmoniques filtrés, les séries temporelles de vecteurs d'admittances comportant des admittances à la fois de la fréquence d'alimentation et de ses harmoniques ;

une étape d'extraction de vecteurs de caractéristiques consistant à extraire des vecteurs de caractéristiques de chacun de la pluralité de dispositifs électriques à partir des séries temporelles de vecteurs d'admittances calculées ; et

une étape d'enregistrement de vecteurs de caractéristiques consistant à enregistrer, sur une base de données, les vecteurs de caractéristiques extraits de la pluralité de dispositifs électriques.

12. Appareil d'estimation d'états de fonctionnement pour le dispositif électrique selon la revendication 1, comprenant :
une unité d'extraction de vecteurs de caractéristiques configurée pour extraire des vecteurs de caractéristiques de chacun de la pluralité de dispositifs électriques à partir des séries temporelles de vecteurs d'admittances calculées.

13. Appareil (300A) d'estimation d'états de fonctionnement pour un dispositif électrique, comprenant :

une unité de mesure de courant-tension (101) configurée pour mesurer un courant et une tension sous forme de séries temporelles à partir d'une ligne d'alimentation électrique à laquelle est reliée une pluralité de dispositifs électriques ;

une unité de filtrage (102) configurée pour filtrer des composantes de signal d'une fréquence d'alimentation et de ses harmoniques à partir des séries temporelles du courant et de la tension mesurés ;

une unité de calcul d'admittances (103) configurée pour calculer des séries temporelles de vecteurs d'admittances à partir à la fois de la fréquence d'alimentation et des harmoniques filtrés, les séries temporelles de vecteurs d'admittances comportant des admittances à la fois de la fréquence d'alimentation et de ses harmoniques ;

une unité de transmission d'admittances (111) configurée pour transmettre les séries temporelles de vecteurs d'admittances calculées à un dispositif serveur (300B) ; et

une unité de réception de résultat estimé (112) configurée pour recevoir un résultat estimé des états de fonctionnement de la pluralité de dispositifs électriques à partir du dispositif serveur (300B).

**14.** Dispositif serveur (300B), comprenant :

une unité de réception d'admittances (113) configurée pour recevoir des séries temporelles de vecteurs d'admittances transmises à partir d'un appareil (300A) d'estimation d'états de fonctionnement, les séries temporelles de vecteurs d'admittances comportant des admittances à la fois de la fréquence d'alimentation et de ses harmoniques ;

une unité de stockage de vecteurs de caractéristiques (106) configurée pour stocker des vecteurs de caractéristiques d'une pluralité de dispositifs électriques ;

une unité de calcul de combinaisons (107) configurée pour calculer des modèles de combinaisons des vecteurs de caractéristiques stockés de la pluralité de dispositifs électriques ; et

une unité de comparaison (108) configurée pour comparer les vecteurs de caractéristiques combinés et les séries temporelles de vecteurs d'admittances reçues dans le but d'obtenir un résultat estimé des états de fonctionnement de la pluralité de dispositifs électriques ; et

une unité de transmission de résultat estimé (114) configurée pour transmettre le résultat estimé obtenu des états de fonctionnement de la pluralité de dispositifs électriques à l'appareil (300A) d'estimation d'états de fonctionnement.

**15.** Système (300) d'estimation d'états de fonctionnement pour un dispositif électrique, comprenant l'appareil (300A) d'estimation d'états de fonctionnement selon la revendication 13 et le dispositif serveur (300B) selon la revendication 14.

# *FIG. 1*

# FIG. 2

```
          ┌──────────────┐
          │    START     │──── ST1
          └──────┬───────┘
                 ↓
   ┌─────────────────────────────┐
   │    TURN ON TARGET DEVICE     │──── ST2
   └──────────────┬──────────────┘
                  ↓
   ┌─────────────────────────────┐
   │        MEASURE Y(n)          │──── ST3
   └──────────────┬──────────────┘
                  ↓
   ┌─────────────────────────────┐
   │    TURN OFF TARGET DEVICE    │──── ST4
   └──────────────┬──────────────┘
                  ↓
          ┌──────────────┐
          │   COMPLETE   │──── ST5
          └──────────────┘
```

# FIG. 3

(a)

COMPOSITE ADMITTANCE

TARGET DEVICE on

TARGET DEVICE off

TARGET DEVICE off

Ybef(n)

Yon(n)

Yaft(n)

SHIFT Yaft(n) AND ADJUST $\tau$aft SO
THAT THESE PHASES
BECOME BEST ACCORDED

(b)

Ybef(n)

Yaft(n)

$\tau$aft

SHIFT Ybef(n) AND ADJUST $\tau$bef SO
THAT THESE PHASES
BECOME BEST ACCORDED

(c)

Yaft(n)

Ybef(n)

$\tau$bef

COMPOSITE THESE PARTS OF Yaft(n)
AND Ybef(n) TO SET THE SAME AS
ESTIMATE VALUE Yoth(n) OF
ADMITTANCE OF OTHER DEVICES

*FIG. 4*

START — ST11

MEASURE Ybef(n) — ST12

TURN ON TARGET DEVICE — ST13

MEASURE Yon(n) — ST14

TURN OFF TARGET DEVICE — ST15

MEASURE Yaft(n) — ST16

MEASURE Yoth(n) — ST17

ESTIMATE Y(n) — ST18

COMPLETE — ST19

*FIG. 5*

$y_2$
(IMAGINARY PART)

$Y_{m2}$

$Y_{m1}$

$Y_{m0}$

$y_1$
(REAL PART)

*FIG. 6*

DEVICE 1
Y10  Y11  Y12

DEVICE 2
Y20  Y21  Y22

DEVICE 3
Y30  Y31  Y32

106

*FIG. 7*

START n-TH FRAME

SET ALL D(n) PATTERNS

SELECT D(n) WHICH MINIMIZES
$| A(Y(n) - \sum_{m=1}^{M} Y_{md_m(n)}) |^2$
FROM ALL PRESET PATTERNS

OBTAIN DEVICE STATE OF n-TH FRAME,
ESTIMATE VALUE D̂(n)

*FIG. 8*

START n-TH FRAME

SET I WAY OF D(n)PATTERNS

SELECT D(n) WHICH MINIMIZES
$| A(Y(n) - \sum_{m=1}^{M} Y_{md_m(n)}) |^2$
FROM I WAY OF PRESET PATTERNS

OBTAIN DEVICE STATE OF n-TH FRAME,
ESTIMATE VALUE D̂(n)

1. ESTIMATE VALUE OF LATEST STATE
2. PATTERN WHICH CHANGES
A PREDETERMINED QUANTITY OF
DEVICE STATES FROM ESTIMATE
VALUE OF LATEST STATE
3. PATTERN WHICH SETS DEVICE STATE
FROM PROBABILITY BASED ON
HISTORIES OF ESTIMATE VALUES IN PAST

# FIG. 9

200

CURRENT/
VOLTAGE

ESTIMATED RESULT
OF OPERATIONAL
STATE OF EACH DEVICE

DATA I/O ~204

HDD ~205

CPU
201

ROM
202

RAM
203

# FIG. 10

300

300A OPERATIONAL STATE ESTIMATING APPARATUS

CLOUD

SERVER DEVICE

300B

PORTABLE TERMINAL

300C

EP 2 840 402 B1

# FIG. 11

## FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002354560 A
- US 20110301894 A
- WO 2011002735 A
- US 20110251807 A

**Non-patent literature cited in the description**

- Nonintrusive Appliance Load Monitoring. **HART G W.** Proceedings of the IEEE. IEEE, 01 December 1992, vol. 80, 1870-1891